# EUROPÄISCHE PATENTSCHRIFT

(11) **EP 0 575 292 B1**
(45) Veröffentlichungstag und Bekanntmachung des Hinweises auf die Patenterteilung: **13.03.1996**
(21) Anmeldenummer: 93810414.8
(22) Anmeldetag: 09.06.1993
(51) Int. Cl.: H05K 3/00, H05K 3/42

(54) **Verfahren zur Herstellung von Substraten mit Durchführungen**
Process for manufacturing substrates with through-holes
Procédé de production de substrats avec des passages débouchants

(30) Priorität: 15.06.1992 CH 1874/92; 15.06.1992 GB 9212648; 17.05.1993 CH 1501/93
(43) Veröffentlichungstag der Anmeldung: 22.12.1993
(73) Patentinhaber: DYCONEX PATENTE AG, Ch-6300 Zug (CH)
(72) Erfinder: Schmidt, Walter, Dr., CH-8050 Zürich (CH); Martinelli, Marco, CH-8413 Neftenbach (CH)
(74) Vertreter: Frei, Alexandra Sarah

(56) Entgegenhaltungen:
- DE-A- 2 141 897
- US-A- 4 118 523
- US-A- 4 472 238
- PATENT ABSTRACTS OF JAPAN vol. 014, no. 229 (E-0928)15. Mai 1990

## Beschreibung

Die Erfindung betrifft ein Verfahren zur Herstellung von Substraten mit Durchführungen, insbesondere Folienleiterplatten mit Durchplattierungen gemäss dem Oberbegriff des ersten, unabhängigen Patentanspruchs sowie eine Leiterplatte und ein Substrat gemäß dem Oberbegriff des Anspruchs 6 bzw. 8.

Die beiden Layouts einer zweilagigen Leiterplatte, die auf beiden Seiten eines flächigen Substrates angeordnet sind, sind üblicherweise elektrisch miteinander verbunden durch durchplattierte Durchführungen durch das Substrat. Diese Durchführungen werden üblicherweise mechanisch gebohrt und dann beispielsweise mit galvanischen Verfahren durchplattiert. Die Layouts der Leiterebenen werden in von der Erstellung der Durchplattierungen weitgehend unabhängigen Verfahrensschritten üblicherweise mit photochemischen und nasschemischen Methoden hergestellt, wobei rund um die beidseitigen Mündungen der Durchplattierungen flächige Erweiterungen der Leiterbahnen, die sogenannten "Lands" vorgesehen werden. Die einer Durchplattierung zugeordneten Lands müssen einander zwangsweise genau gegenüberliegend angeordnet sein und sie müssen mindestens derart gross sein, dass sie auch bei Aufsummierung aller im Verfahren möglichen Ungenauigkeiten noch rund um die Mündung der Durchplattierung reichen.

Die obere Grenze der Funktionsdichte derartiger Leiterplatten wird unter anderem bestimmt durch den Durchmesser der gebohrten Durchführungen, der minimal ca 0,2 mm beträgt, und durch die Abmessungen der dazugehörigen Lands. Diese obere Grenze, wie sie nach den Methoden mit gebohrten Löchern erreicht wird, ist seit langem für die an Leiterplatten gestellten Anforderungen viel zu tief und wird deshalb durch Aufeinanderschichten einer Vielzahl von Leiterbahnebenen umgangen. Die einer derartigen Entwicklung inhärenten Nachteile sind bekannt und führten zum Wunsch nach einer Erhöhung der Funktionsdichte innerhalb der Leiterebenen, damit die notwendige Anzahl der Leiterebenen wieder beschränkt werden kann.

Dazu bietet die Folientechnik diverse Möglichkeiten, wobei dünne Leiterplatten aus metallkaschiertem Folienmaterial hergestellt werden und die Durchführungen für die Durchplattierungen nicht gebohrt, sondern geätzt, insbesondere plasmageätzt werden. Das Ausgangsprodukt ist üblicherweise eine beidseitig mit Metall, beispielsweise Kupfer, beschichtete Folie aus einem elektrisch isolierenden Polymer, beispielsweise Polyimid oder Epoxidharz.

Zur Erstellung der Durchplattierungen werden die Metallschichten an den Stellen der Mündungen der vorgesehenen Durchführungen beidseitig entfernt, was auf photochemischem Wege möglich ist. Dann wird die Polymerschicht an den freigelegten Stellen von beiden Seiten zu einem durchgehenden Loch durchgeätzt, beispielsweise durch Plasmaätzen. Diese Durchführungen werden beispielsweise mit galvanischen Methoden durchplattiert. Danach werden in weiteren, üblicherweise photochemischen Prozessschritten die Layouts auf den Metallschichten strukturiert.

Nach einem derartigen Verfahren hergestellte Durchplattierungen können ohne weiteres Durchmesser von bis hinunter zu etwa fünf Hundertstel Millimetern aufweisen, wodurch die Funktionsdichte gegenüber der eingangs erwähnten Bohrmethode drastisch erhöht wird. Der Dimensionierung und Positionierung der Lands kommt bei diesem Verfahren eine hohe Wichtigkeit zu, denn es sind ja nicht nur die Durchplattierungen an sich, sondern auch die Lands, die in den Leiterebenen Platz beanspruchen und dadurch die Funktionsdichte bestimmen.

Da aber die Grössenordnungen für Leiterstrukturen hergestellt nach der Folientechnik, verglichen mit den durch Bohrtechnik erreichbaren Grössenordnungen, um ca. eine Zehnerpotenz kleiner sind, fallen Layout-Zwänge bedingt durch die Durchplattierungen und deren Toleranzen entsprechend mehr ins Gewicht, insbesondere da die Toleranzen die gleiche Grössenordnung beibehalten. Es wäre also wünschenswert, für eine optimale Ausnützung der Vorteile der Folientechnik derartige Layout-Zwänge mildern oder umgehen zu können.

Dies wird möglich, wenn für Durchplattierungen auch schiefe Durchführungen, das heisst Durchführungen, deren Achsen nicht senkrecht auf der flächigen Ausdehnung des Substrates stehen, vorgesehen werden. Derartige schiefe Durchführungen sind mittels Ätztechnik erstellbar, wobei je nach Versatz der beiden für die Mündungen der Durchführung vorgesehenen Ätzfenster, z.Bop. Öffnungen in den Metallkaschierungen, eine stärkere oder weniger starke Unterätzung der Folie notwendig ist.

Ein Verfahren gemäß der vorliegenden Erfindung ist in Anspruch 1 definiert. Eine erfindungsgemäße Leiterplatte und ein erfindungsgemäßes Substrat sind in den unabhängigen Ansprüchen 6 und 8 definiert.

Ein Miteinbezug von schiefen Durchführungen durch das Substrat für Durchplattierungen und eine entsprechende Wahl der Ätzparameter erlauben eine weitere Erhöhung der Funktionsdichte innerhalb einer Leiterebene aus zwei Gründen:

Einerseits erlaubt der Einbezug von nicht senkrecht zur Fläche des Substrates verlaufenden Durchführungen in die Auslegung des Layouts eine begrenzte Freiheit in der Positionierung der Lands, die einer Durchplattierung zugeordnet sind, das heisst eine Milderung des Layout-Zwanges der einander gegenüberliegenden Lands. Diese Lands müssen nicht mehr zwangsweise einander exakt gegenüber liegen, sondern können, mindestens in beschränktem Masse gegeneinander verschoben sein, wodurch eine beschränkte Freiheit des einen Layouts gegenüber dem anderen entsteht, die für Platzeinsparungen und/oder Leiterverkürzungen ausgenützt werden kann. Es wird auf diese Weise auch möglich, sich verzweigende Durchführungen herzustellen, das heisst, Durchführungen mit einer Mündung auf der einen Substratseite und mehreren Mündungen auf der anderen Substratseite, was neue Freiheitsgrade im Design von Leiterplatten oder anderen Substraten ergibt.

Andererseits kann durch die Möglichkeit der schiefen Durchführungen die durch Toleranzbedingungen notwendige Grösse der Lands eingeschränkt werden, weil ein Versatz der beiden Durchführungsmündungen nicht mit einbezogen werden muss. Dieser Versatz wird bedeutungslos, wenn das geätzte Loch einfach die beiden vorgegebenen Mündungen verbindet, ob nun diese beiden Mündungen gegeneinander versetzt sind oder nicht. In die Berechnung für die minimal notwendige Grösse der Lands müssen also nur Ungenauigkeiten mit einbezogen werden, die sich auf die eine Seite der Leiterplatte beziehen. Die relative Position des Layouts der einen Seite relativ zum Layout der anderen Seite kann ausser Acht gelassen werden. Dafür müssen die Ätzparameter derart eingestellt werden, dass auch bei einer maximal erwarteten Versatz-Ungenauigkeit noch ein durchgehendes Loch durch das Substrat entsteht.

US-A-4 118 523 offenbart ein Verfahren gemäß den Oberbegriff des Anspruchs 1 und eine Leiterplatte sowie ein Substrat gemäß dem Oberbegriff der Ansprüche 6 und 8.

Anhand der nachfolgend aufgeführten Figuren werden einige Beispiele des erfindungsgemässen Vorgehens diskutiert.
- **Figuren 1a und 1b**: zeigen schematisch durch metallkaschierte Folien geätzte Löcher ohne Unterätzung und mit Unterätzung.
- **Figur 2**: zeigt eine mögliche Auswirkung eines Layout-Versatzes zwischen den beiden Seiten des Substrates bei gebohrten Durchführungen.
- **Figur 3**: zeigt die Auswirkung eines Layout-Versatzes bei geätzten Durchführungen.
- **Figur 4**: zeigt beispielhaft Grössenordnungen für Durchplattierungen durch eine Folienleiterplatte.
- **Figur 5**: zeigt ein Beispiel für schiefe Durchplattierungen durch eine Folienleiterplatte.
- **Figuren 6 und 7**: zeigen Ansichten der Ober- und Unterseite der Folienleiterplatte gemäss Figur 5.
- **Figur 8**: zeigt eine verzweigte Durchführung nach dem Ätzen und
- **Figur 9**: die verzweigte Durchführung von Figur 4 nach dem Durchplattieren.
- **Figur 10**: zeigt in räumlicher Darstellung, wie eine 1-zu-2-Durchführung aussehen kann.

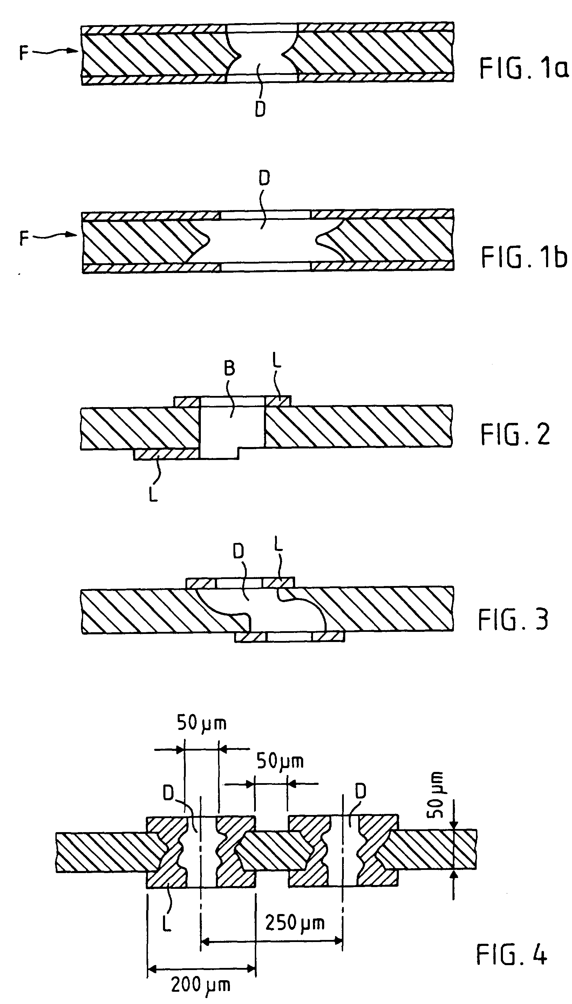

**Figuren 1a und 1b** zeigen geätzte Durchführungen D durch beidseitig metallkaschiertes Folienmaterial F, wobei zur Herstellung der Durchführung gemäss Figur 1a die Ätzparameter derart gewählt wurden, dass gerade eine Durchführung entsteht, was bei dem dargestellten Verhältnis der Substratdicke zum Durchmesser der vorgesehenen Mündung zu keiner Unterätzung führt. Figur 1b zeigt dieselbe Durchführung mit einer offensichtlichen Unterätzung. Aus verfahrensökonomischen Gründen ist die Ätzung gemäss Figur 1a vorzuziehen, sie ist aber im Hinblick auf einen Versatz der beiden Mündungen, wie im Zusammenhang mit der Figur 3 noch beschrieben wird, eventuell nicht genügend.

**Figur 2** zeigt ein Stück Leiterplatte mit einer gebohrten Durchführung B und beidseitigen, dieser Durchführung zugeordneten Lands L, die beabsichtigt oder unbeabsichtigt gegeneinander verschoben sind. Bedingt durch diesen Versatz umgibt das Land der unteren Seite die Mündung der Durchführung nur teilweise, was beim Durchplattieren zu Ausschuss führt. Der Ausschuss wäre zu verhindern durch grössere Lands, die aber auf der Leiterebene entsprechend mehr Platz benötigen, also die Funktionsdichte herabsetzen, oder durch die Herstellung eines schiefen Loches, was mit Bohren sozusagen unmöglich ist.

**Figur 3** zeigt nun eine geätzte Durchführung D, wobei die der Durchführung zugeordneten Lands L aus Toleranzgründen oder aus Layoutgründen gegeneinander verschoben sind. Die Durchführung ist schief und es auch ersichtlich, dass, je grösser der Versatz der Lands, desto grösser die Unterätzung, die notwendig ist, damit die Durchführung wirklich durch das Substrat reicht. Das heisst mit anderen Worten, dass die Ätzparameter derart eingerichtet werden müssen, dass die schiefste Durchführung noch durchgeätzt werden kann und dass trotzdem die Unterätzung auch bei weniger schiefen Durchführungen noch tolerierbar ist. Diese Bedingung liefert gleichzeitig die obere Begrenzung für die Schiefheit einer Durchführung, wobei diese ihrerseits aber auch von der Dicke des Substrates, vom Durchmesser der Mündungen und vom Material des Substrates abhängig ist.

**Figur 4** zeigt einen Schnitt durch einen Bereich einer beispielhaften Folienleiterplatte mit zwei Leiterebenen. Der Schnitt zeigt zwei senkrechte Durchplattierungen D und deren Grössenordnungen. Die geätzten Durchführungen durch das Substrat mit einer Dicke von 50µm haben einen Durchmesser von 50µm, die Lands L einen Durchmesser von 200µm. Zwischen den Lands ist ein Abstand von 50µm vorgesehen.

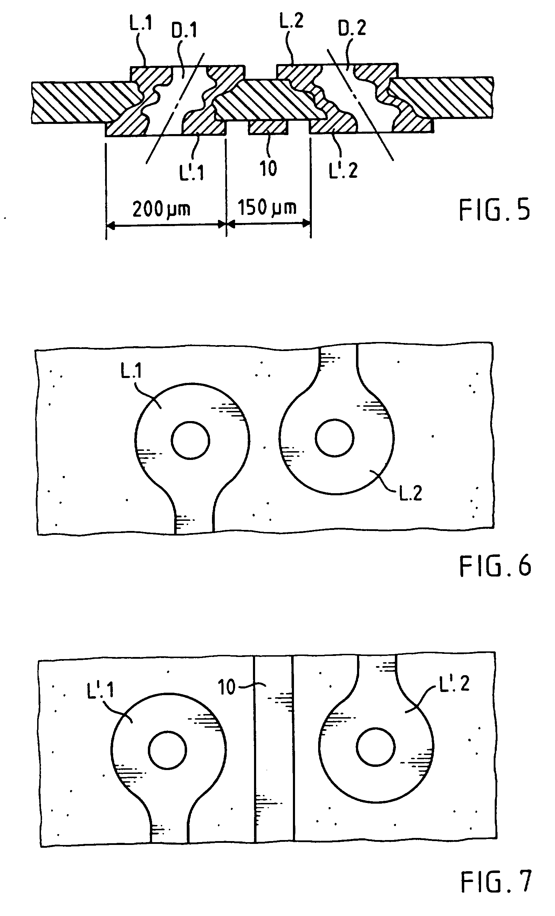

**Figur 5** zeigt nun an einem Beispiel die Unabhängigkeit der beiden Layouts voneinander, wenn durch eine gleiche Folienleiterplatte, wie sie in Figur 4 dargestellt ist, schiefe Durchplattierungen D.1 und D.2 vorgesehen werden können. Der Abstand zwischen den beiden Lands L.1 und L.2 beträgt auf dem oberen Layout 50µm (wie in Figur 4), auf dem unteren 150µm, derart, dass zwischen den Lands L'.1 und L'.2, wie dargestellt, ein Leiter 10 vorgesehen werden kann.

**Figuren 6 und 7** zeigen als Draufsichten die der Figur 5 entsprechenden Bereiche des oberen und des unteren Layouts der Folienleiterplatte.

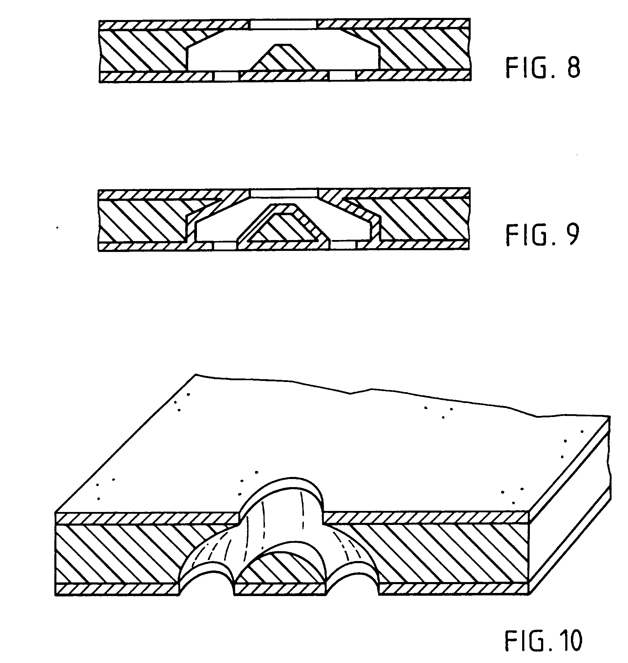

**Figur 8** zeigt nun die konsequente Weiterentwicklung der Idee, nämlich eine kaschierte Folie beispielsweise zur Leiterplattenherstellung mit einer Durchführungsmündung auf der einen und mit dieser verbunden zwei Durchführungsmündungen auf der anderen Seite. Die Durch- und Unterätzung ist stilistisch dargestellt, aber man sieht, dass die Kanäle miteinander verbunden sind. Nach dem Durchplattieren (Figur 9) erhält man eine verzweigte Durchführung, die für verschiedene Zwecke nützlich sein kann. Figur 10 zeigt dieselbe verzweigte Durchführung als räumliche Darstellung eines Schnittes.

Obschon die Erfindung lediglich an dünnen Folien von 25 - 100 µm ausprobiert wurde, kann das Verfahren auch für dickere Substrate verwendet werden. Die physikalischen Grenzen sind hier nicht durch das Verfahren per se sondern durch die verwendete Ätztechnik gesetzt.

Üblicherweise werden für Durchplattierungen in Anlehnung an die Bohrtechnik Durchführungen mit runden Mündungen erstellt. Mit der Ätztechnik, bspw. Plasmaätzen, können aber natürlich auch Durchführungen mit verschiedenen Mündungsformen entstehen, bspw. Eingangsmündung viereckig und zwei Ausgangsmündungen oval und so fort. Die Durchführungen können auch an Substraten erstellt werden, die nicht zu Leiterplatten weiterverarbeitet werden. Für derartige Substrate können dann die Mündungen der Durchführungen an jegliche Anschlussform angepasst werden.

Selbstverständlich können die beschriebenen und in den Figuren dargestellten zweilagigen Leiterplatten durch Aufbringen mehrerer Folienlagen zu vielschichtigen Folienleiterplatten weiterverarbeitet werden.

## Patentansprüche

1. Verfahren zur Herstellung von Substraten mit Durchführungen (D), insbesondere Foliensubstraten, zur Herstellung von Leiterplatten mit Durchführungen für Durchplattierungen, wobei auf beiden Seiten des Substrates an den Stellen der Durchführungsmündungen Ätzfenster angelegt werden und das Substrat durch diese Fenster durchgeätzt wird, **dadurch gekennzeichnet,** dass die für die Ätzung einer Durchführung (D) vorgesehenen Ätzfenster in der Projektion in Richtung senkrecht zur Oberfläche des Substrats gegeneinander versetzt sind und dass die Ätzparameter derart eingestellt werden, dass eine Unterätzung der Fenster entsteht, die so gross ist, dass auch die Durchführung mit den am meisten versetzten Ätzfenstern durchgehend geätzt wird.

2. Verfahren nach Anspruch 1, **dadurch gekennzeichnet,** dass Fenster so angelegt werden, dass eine Mündung auf einer Seite mit mehr als einer Mündung auf der anderen Seite durchgängig miteinander verbunden ist.

3. Verfahren nach Anspruch 2, **dadurch gekennzeichnet,** dass eine beliebige Zahl von Fenstern jeder Seite miteinander durchgängig verbunden werden.

4. Verfahren nach einem der Ansprüche 1 bis 3, **dadurch gekennzeich**net, dass das Material, aus dem die Fenster ausgenommen werden, zu einem Layout-Bild weiterverarbeitet wird.

5. Verfahren nach Anspruch 4, **dadurch gekennzeichnet**, dass das Layout-Bild ein Leiterbild einer Leiterplatte ist.

6. Leiterplatte, herstellbar nach dem Verfahren nach Anspruch 1, die geatzte Durchführungen (D) aufweist,**dadurch gekennzeichnet,** daß die Projektionen von Ein- und Ausmündung in Richtung senkrecht zur Oberfläche der Leiterplatte nicht zusammenfallen.

7. Leiterplatte nach Anspruch 6, **dadurch gekennzeichnet**, dass sie Durchplattierungen der Durchführungen aufweist.

8. Substrat, herstellbar nach dem Verfahren nach Anspruch 1, das geätzte Durchführungen (D) aufweist, **dadurch gekennzeichnet,** daß die Projektionen der Ein- und Ausmündung in Richtung senkrecht zur Oberfläche des Substrats nicht zusammenfallen und insbesondere eine Mündung mit mehr als einer anderen Mündung verbunden ist.

## Claims

1. Process for producing substrates with feed-throughs (D), particularly foil substrates, for the production of circuit boards with feed-throughs for plated-through holes and on both sides of the substrate, at the locations of the feed-through openings, etching windows are made and the substrate is etched through these windows, characterized in that the etching windows provided for etching a feed-through (D) are mutually displaced in the projection in the direction perpendicular to the substrate surface and that the etching parameters are so set that an undercutting of the windows is obtained, which is sufficiently large that also through-etching takes place of the feed-through with the most displaced etching windows.

2. Process according to claim 1, characterized in that the windows are provided in such a way that an opening on one side is through-linked with more than one opening on the other side.

3. Process according to claim 2, characterized in that a random number of windows of each side are through-linked.

4. Process according to one of the claims 1 to 3, characterized in that the material from which the windows are taken is further processed to a layout pattern.

5. Process according to claim 4, characterized in that the layout pattern is a conductor pattern of a circuit board.

6. Circuit board, produced according to the process of claim 1, which has etched feed-throughs (D), characterized in that there is coincidence of the projections of the inlet and outlet openings in a direction perpendicular to the circuit board surface.

7. Circuit board according to claim 6, characterized in that it has plated-through holes of the feed-throughs.

8. Substrate produced according to the process of claim 1, which has etched feed-throughs (D), characterized in that the projections of the inlet and outlet openings in the direction perpendicular to the substrate surface do not coincide and in particular one opening is connected to more than one other opening.

## Revendications

1. Procédé pour la fabrication de substrats avec des passages (D), en particulier des passages de substrats de films, pour la fabrication de cartes de circuits imprimés avec des passages pour des trous métallisés, des fenêtres de gravure étant placées des deux côtés du substrat aux endroits des ouvertures de passage et le substrat étant attaqué par ces fenêtres, caractérisé en ce que les fenêtres de gravure prévues pour l'attaque d'un passage (D) sont décalées les unes par rapport aux autres en saillie dans le ens perpendiculaire à la surface du substrat et en ce que les paramètres de gravure sont ajustés de telle façon qu'il se forme une gravure sous-jacente des fenêtres qui est si grande que le passage est attaqué en continu avec les fenêtres de gravure généralement décalées.

2. Procédé selon la revendication 1, caractérisé en ce que les fenêtres sont disposées de façon qu'une ouverture d'un côté soit reliée en permanence à plus d'une ouverture de l'autre côté.

3. Procédé selon la revendication 2, caractérisé en ce qu'un nombre quelconque de fenêtres de chaque côté sont reliées entre elles en permanence.

4. Procédé selon l'une quelconque des revendications 1 à 3, caractérisé en ce que le matériau dans lequel les fenêtres sont prélevées, est transformé en une image d'ébauche.

5. Procédé selon la revendication 4, caractérisé en ce que l'image de l'ébauche est un dessin de conducteurs d'une carte de circuits comprimés.

6. Carte de circuits imprimés pouvant être fabriquée d'après le procédé selon la revendication 1, qui présente des passages (D) gravés, caractérisée en ce que les saillies de l'entrée et de la sortie ne coïncident pas dans le sens perpendiculaire à la surface de la carte de circuits imprimés.

7. Carte de circuits imprimés selon la revendication 6, caractérisée en ce qu'elle présente des trous métallisés pour les passages.

8. Substrat, pouvant être fabriqué d'après le procédé selon la revendication 1, qui présente des passages (D) gravés, caractérisé en ce que les saillies de l'entrée et de la sortie ne coïncident pas dans le sens perpendiculaire à la surface du substrat et en particulier en ce qu'une ouverture est reliée à plus d'une autre ouverture.
